# EUROPEAN PATENT APPLICATION

(11) **EP 2 071 789 A2**
(43) Date of publication of application: **17.06.2009**
(21) Application number: 08020849.9
(22) Date of filing: 01.12.2008
(51) Int. Cl.: H04L 27/26

(54) **Method and system for ADC calibration in OFDM systems**

(30) Priority: 12.12.2007 US 954364
(71) Applicant: Broadcom Corporation, Irvine 92617 (US)
(72) Inventor: Ahmadreza, Rofougaran, Newport Coast, CA 92657 (US)
(74) Representative: Jehle, Volker Armin

(57) **Abstract**

Aspects of a method and system for ADC calibration in OFDM systems may include receiving a plurality of Orthogonal Frequency Division Multiplexing (OFDM) tones at an OFDM receiver comprising a ping-pong Analog-to-Digital Converter (ADC) and a Fast-Fourier Transform (FFT). A transfer function of the ping-pong ADC may be calibrated via one or more adjustment coefficients at one or more corresponding outputs of the FFT, based on processing of the plurality of the OFDM tones. The plurality of OFDM tones may be received in an OFDM preamble, or the received plurality of OFDM tones may be generated in a calibration signal generator. The output levels of the outputs of the FFT may be equalized to achieve the calibration of the transfer function. The adjustment coefficients may be varied, and said calibrating may be performed dynamically.

## Description

### CROSS-REFERENCE TO RELATED APPLICATIONS/INCORPORATION BY REFERENCE

Not applicable.

### FIELD OF THE INVENTION

Certain embodiments of the invention relate to signal processing for communication systems. More specifically, certain embodiments of the invention relate to a method and system for ADC calibration in OFDM systems.

### BACKGROUND OF THE INVENTION

Electronic communication has become prolific over the last decade. While electronic communication was initially limited to the desktop, recent trends have been to make communications, media content and the Internet available anytime, anywhere and, increasingly, on any device. Already now, it is quite common to find mobile devices such as cellular phones or Personal Digital Assistants (PDAs) that incorporate a large range of communication technologies and associated software. For example, fully-featured web-browsers, email clients, MP3 players, instant messenger software, and Voice-over-IP may all be found on some recent devices.

Currently, there are many different communication technologies and protocols, some of which may utilize common data formats and while others may utilize different data formats. Today's mobile communication devices have to support these man different communication technologies, protocols and/or data formats.

Further limitations and disadvantages of conventional and traditional approaches will become apparent to one of skill in the art, through comparison of such systems with some aspects of the present invention as set forth in the remainder of the present application with reference to the drawings.

### BRIEF SUMMARY OF THE INVENTION

A method and/or system for ADC calibration in OFDM systems, substantially as shown in and/or described in connection with at least one of the figures, as set forth more completely in the claims.
According to an aspect, a method for processing communication signals is provided, the method comprising:
receiving a plurality of Orthogonal Frequency Division Multiplexing (OFDM) tones at an OFDM receiver comprising a ping-pong Analog-to-Digital Converter (ADC) and a Fast-Fourier Transform (FFT); and
calibrating a transfer function of said ping-pong ADC via one or more adjustment coefficients at one or more corresponding outputs of said FFT, based on processing of said plurality of said OFDM tones.
Advantageously, the method further comprises receiving said plurality of OFDM tones in an OFDM preamble.
Advantageously, said received plurality of OFDM tones is generated in a calibration signal generator.
Advantageously, the method further comprises equalizing output levels of said outputs of said FFT to achieve said calibration of said transfer function.
Advantageously, the method further comprises varying said one or more adjustment coefficients.
Advantageously, the method further comprises performing said calibrating dynamically.
Advantageously, said transfer function of said ping-pong ADC is frequency-selective.
Advantageously, said ping-pong ADC comprises a plurality of ADCs.
Advantageously, the method further comprises interpolating between adjustment coefficients corresponding to said plurality of OFDM tones to generate one or more adjustment coefficients.
Advantageously, the method further comprises adjusting a frequency response of said OFDM receiver to achieve said calibrating.
According to an aspect, a system for processing communication signals comprises:
one or more circuits in an Orthogonal Frequency Division Multiplexing (OFDM) receiver, said one or more circuits comprising a ping-pong Analog-to-Digital Converter (ADC) and a Fast-Fourier Transformer (FFT), wherein said one or more circuits are enabled to:
   receive a plurality of Orthogonal Frequency Division Multiplexing (OFDM) tones by said OFDM receiver; and
   calibrate a transfer function of said ping-pong ADC via one or more adjustment coefficients at one or more corresponding outputs of said FFT, based on a processing of said plurality of said OFDM tones.
Advantageously, said one or more circuits receive said plurality of OFDM tones in an OFDM preamble.
Advantageously, said received plurality of OFDM tones is generated in a calibration signal generator.
Advantageously, said one or more circuits equalize output levels of said outputs of said FFT to achieve said calibration of said transfer function.
Advantageously, said one or more circuits vary said one or more adjustment coefficients.
Advantageously, said one or more circuits perform said calibrating dynamically.
Advantageously, said transfer function of said ping-pong ADC is frequency-selective.
Advantageously, said ping-pong ADC comprises a plurality of ADCs.
Advantageously, said one or more circuits interpolate between adjustment coefficients corresponding to said plurality of OFDM tones to generate one or more adjustment coefficients.
Advantageously, said one or more circuits adjust a frequency response of said OFDM receiver to achieve said calibrating.

These and other advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1 is a diagram illustrating an exemplary wireless communication system, in accordance with an embodiment of the invention.

FIG. 2A is a diagram illustrating an exemplary transmitted OFDM signal, in accordance with an embodiment of the invention.

FIG. 2B is a diagram illustrating an exemplary received OFDM signal in a frequency-selective channel, in accordance with an embodiment of the invention.

FIG. 2C is a diagram illustrating an exemplary OFDM receiver with a ping-pong ADC and frequency equalization, in accordance with an embodiment of the invention.

FIG. 3 is a flow chart illustrating an exemplary ADC calibration process for OFDM, in accordance with an embodiment of the invention.

### DETAILED DESCRIPTION OF THE INVENTION

Certain embodiments of the invention may be found in a method and system for ADC calibration in OFDM systems. Aspects of a method and system for ADC calibration in OFDM systems may comprise receiving a plurality of Orthogonal Frequency Division Multiplexing (OFDM) tones at an OFDM receiver comprising a ping-pong Analog-to-Digital Converter (ADC) and a Fast-Fourier Transform (FFT). A transfer function of the ping-pong ADC may be calibrated via one or more adjustment coefficients at one or more corresponding outputs of the FFT, based on processing of the plurality of the OFDM tones. The plurality of OFDM tones may be received in an OFDM preamble, or the received plurality of OFDM tones may be generated in a calibration signal generator. The output levels of the outputs of the FFT may be equalized to achieve the calibration of the transfer function. The adjustment coefficients may be varied, and said calibrating may be performed dynamically. The transfer function of the ping-pong ADC may be frequency-selective, and the ping-pong ADC may comprise a plurality of ADCs. One or more adjustment coefficients may be generated by interpolating between adjustment coefficients corresponding to said plurality of OFDM tones. A frequency response of said OFDM receiver may be adjusted to achieve said calibrating.

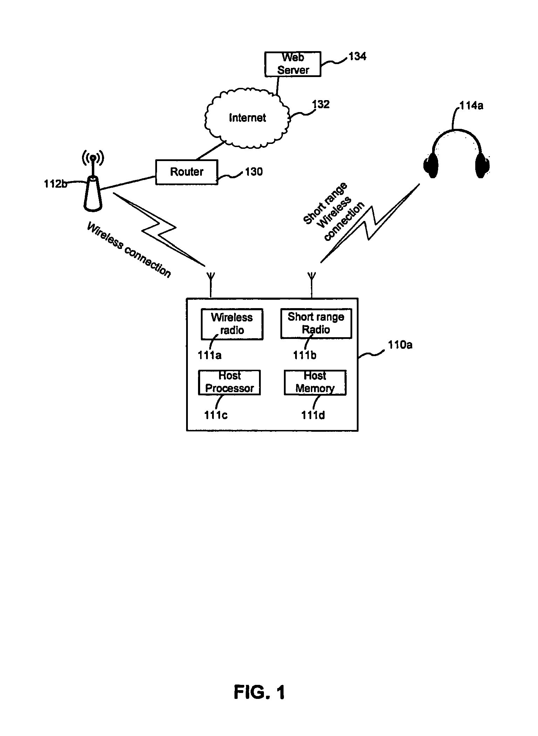

FIG. 1 is a diagram illustrating an exemplary wireless communication system, in accordance with an embodiment of the invention. Referring to FIG. 1, there is shown a base station 112b, a computer 110a, a headset 114a, a router 130, the Internet 132 and a web server 134. The computer or host device 110a may comprise a wireless radio 111 a, a short-range radio 111 b, a host processor 111 c, and a host memory 111 d. There is also shown a wireless connection between the wireless radio 111 a and the base station 112b, and a short-range wireless connection between the short-range radio 111 b and the headset 114a.

The base station 112b may comprise suitable logic, circuitry and/or code that may be enabled to transmit and receive radio frequency signals for data communications, for example with the wireless radio 111 a. The base station 112b may also be enabled to communicate via a wired network, for example, with the router 130. The wireless radio 111 a may comprise suitable logic, circuitry and/or code that may enable communications over radio frequency waves with one or more other radio communication devices. The wireless radio 111a and the base station 112b may be compliant with one or more mobile communication standard, for example, IEEE 802.11, 3GPP LTE, or WiMAX OFDM. The short range radio 111 b may comprise suitable logic, circuitry and/or code that may enable communications over radio frequencies with one or more other communication devices, for example the headset 114a. The short range radio 111b and/or the headset 114a may be compliant with a wireless industry standard, for example Bluetooth, or IEEE 802.11 Wireless LAN. The host processor 111c may comprise suitable logic, circuitry and/or code that may be enabled to generate and process data. The host memory 111d may comprise suitable logic, circuitry and/or code that may be enabled to store and retrieve data for various system components and functions of the computer 110a. The router 130 may comprise suitable logic, circuitry and/or code that may be enabled to communicate with communication devices that may be communicatively coupled to it, for example base station 112b or the Internet 132. The Internet 132 may comprise suitable logic, circuitry and/or code that may be enabled to interconnect and exchange data between a plurality of communication devices. The web server 134 may comprise suitable logic, circuitry and/or code that may be enabled to communicate with communication devices that may be communicatively coupled to it, for example the Internet 132.

Frequently, computing and communication devices may comprise hardware and software that may enable communication using multiple wireless communication standards and/or protocols. There may be instances when the wireless radio 111 a and the short-range radio 111b may be active concurrently. For example, it may be desirable for a user of the computer or host device 110a to access the Internet 132 in order to consume streaming content from the Web server 134. Accordingly, the user may establish a wireless connection between the computer 110a and the base station 112b. Once this connection is established, the streaming content from the Web server 134 may be received via the router 130, the base station 112b, and the wireless connection, and consumed by the computer or host device 110a.

In some instances, the channel of the wireless connection or the short-range wireless connection, for example between the base station 112b and the wireless radio 111 a, may be frequency-selective. A frequency-selective channel may lead to different attenuation of frequencies across the transmitted signal bandwidth. This channel distortion may add to system impairments that may also affect the signal characteristics at different frequencies, for example, in the analog-to-digital converter (ADC). In these instances, it may be desirable to equalize the overall system transfer function to obtain an approximately equal attenuation across different operating frequencies.

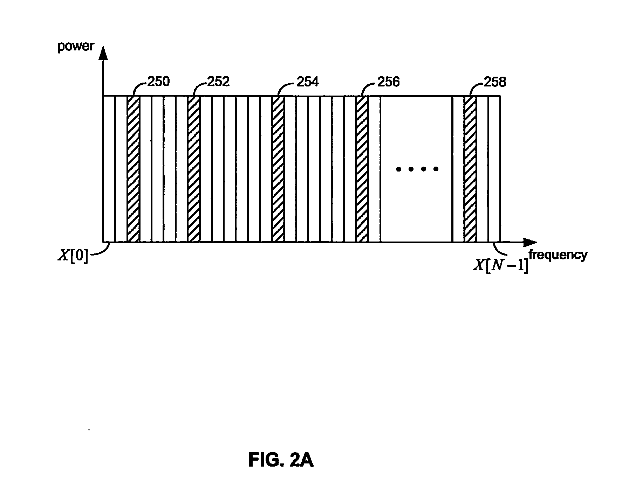

FIG. 2A is a diagram illustrating an exemplary transmitted OFDM signal, in accordance with an embodiment of the invention. Referring to FIG. 2A, there is shown a power versus frequency diagram, illustrating an Orthogonal Frequency Division Multiplexing (OFDM) frequency band, comprising of a plurality of sub-bands, also referred to as tones *X*[0] to *X*[*N*-1]. There is also shown a plurality of pilot tones 250, 252, 254, 256 and 258 in a hatch pattern. The plurality of pilot tones may comprise an arbitrary number of pilot tones. The plurality of pilot tones 250, ... , 258 may form an OFDM pre-amble. The plurality of pilot tones 250, ... , 258 may be used to send, for example, known data from the transmitter to the receiver. Since the data may be known to the receiver, the received pilot tones may be used by the receiver to estimate the channel transfer function, and the receiver parameters may be adjusted in function of the channel transfer function to enhance receiver performance. As illustrated in FIG. 2A, the pilot tones 250, ..., 258 may be distributed across the entire bandwidth used by the OFDM signal. In this manner, the set of channel estimations from the pilot tones may be used to approximate the channel response across the entire signal bandwidth.

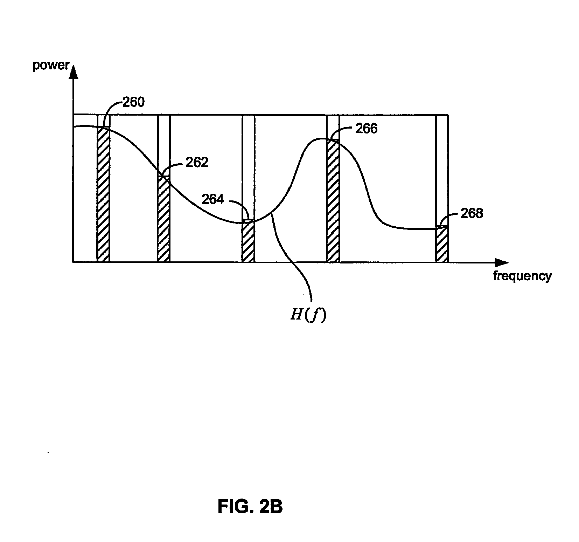

FIG. 2B is a diagram illustrating an exemplary received OFDM signal in a frequency-selective channel, in accordance with an embodiment of the invention. Referring to FIG. 2B, there is shown a plurality of received OFDM pilot tones 260, 262, 264, 266, and 268 in a hatch pattern. The pilot tones 260, ..., 268 may be substantially similar to attenuated pilot tones 250, ..., 258, respectively, in FIG. 2A. There is also shown an exemplary channel transfer function, H(f).

As illustrated in FIG. 2B, in instances where the received OFDM signal may traverse a frequency-selective channel, different pilot tones at different frequencies may be attenuated differently. For example, as illustrated in FIG. 2B, the pilot tones 264 and 268, may be attenuated much more than the pilot tones 260 and 266. In these instances, the signal that may result may suffer from potentially severe distortion since its frequency spectrum may change significantly because of the transmission channel, as illustrated in FIG. 2B. To avoid distortions, it may be desirable to adjust the received signal at various frequencies to compensate for the different attenuation factors, so that the corrected signal may resemble FIG. 2A, wherein the pilot-tones may be of equal amplitudes. This process may be referred to as frequency equalization, or channel equalization. Since the receiver may be aware that the pilot-tones may have been transmitted, for example, with an equal power levels, it may be desirable to compare the received signal power levels of the pilot tones to each other, to determine how the pilot tone gains may be adjusted. To reduce mismatch between the in-phase and quadrature signal components, it may be desirable to compare signal phases.

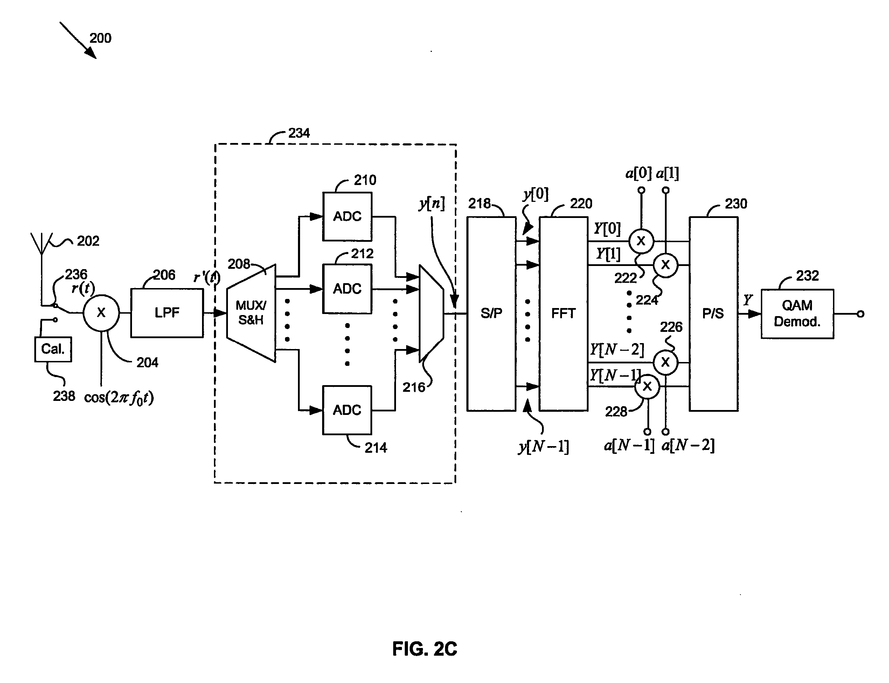

In addition, the received signal frequency response may also be distorted due to circuitry used in the RF processing chain. For example, a receiver antenna, an RF input low-pass filter, and an Analog-to-Digital Converter (ADC) may introduce frequency distortion. In these instances, the various transfer functions may result in a cumulative overall frequency-selective channel response which may be corrected for at base band, as illustrated in FIG. 2C.

FIG. 2C is a diagram illustrating an exemplary OFDM receiver with a ping-pong ADC and frequency equalization, in accordance with an embodiment of the invention. Referring to FIG. 2C, there is shown an OFDM receiver 200. The OFDM receiver 200 may comprise an antenna 202, a switch 236, a calibration signal generator 238, a demodulator 204, a low-pass filter (LPF) 206, a ping-pong Analog-to-Digital Converter (ADC) 234, a serial-to-parallel converter (S/P) 218, a Fast Fourier Transform (FFT) block 220, a plurality of multipliers, of which multipliers 222, 224, 226, and 228 may be illustrated, a parallel-to-serial converter (P/S) 230, and a Quadrature Amplitude Modulation (QAM) demodulator 232. The ping-pong ADC 234 may comprise multiplexers (MUX) 208 and 216, and a plurality of Analog-to-Digital Converter (ADCs), of which ADC 210, 212, and 214 may be illustrated. In some instances, the MUX 208 may be replaced by a plurality of parallel sample-and-hold circuits, one corresponding to each signal path corresponding to one ADC of the plurality of ADC, of which ADC 210, 212, and 214 may be illustrated. In these instances, the multiplexing may be achieved by clocking the parallel sample-and-hold circuits with desirable phase shifts. There is also shown a received signal *r*(*t*), a band-limited received baseband signal *r'*(*t*), a carrier frequency cos(2π*f*₀*t*), a digital baseband signal *y*[*n*], a Discrete Fourier Transform (DFT) signal *Y*[*n*], adjustment coefficients *a*[*n*], and a modulated output signal *Y*.

The calibration signal generator 238 may comprise suitable logic, circuitry and/or code that may be enabled to generate a reference OFDM signal. The switch 236 may comprise suitable logic, circuitry and/or code that may be enabled to switch the input of the OFDM receiver 200 between the antenna and the calibration signal generator 238. The antenna 202 may comprise suitable logic, circuitry and/or code that may be enabled to receive a radio frequency signal by converting radio waves in an electric voltage and/or current. The demodulator 204 may comprise suitable logic, circuitry and/or code that may be enabled to downconvert a received radio frequency signal to a base band signal. In accordance with various embodiments of the invention, the demodulator may in some instances convert the radio frequency to an intermediate frequency, followed by a conversion from intermediate frequency to baseband.

The LPF 206 may comprise suitable logic, circuitry and/or code that may be enabled to limit the bandwidth of the received signal and reject unwanted signal components that may be, for example, generated during the downconversion process in the demodulator 204. The ping-pong ADC 234 may comprise suitable logic, circuitry and/or code that may be enabled to convert an analog signal into a digital signal by sampling. As illustrated in FIG. 2C, the ping-pong ADC 234 may comprise a plurality of ADCs in parallel. The ADCs 210, ..., 214 may be substantially similar and may comprise suitable logic, circuitry and/or code that may be enabled to convert an analog input signal into corresponding digital output samples. The multiplexer 208 may comprise suitable logic, circuitry and/or code that may be enabled to switch an input signal between a number of outputs. The multiplexer 216 may comprise suitable logic, circuitry and/or code that may be enabled to switch a number of inputs into a single output signal. This parallel structure of the ping-pong ADC 234 may allow to use multiple slower-speed ADCs in parallel to achieve very high ADC rates overall. For example, in accordance with an exemplary embodiment of the invention, a 2 GHz signal may be sampled at 2 GHz by utilizing, for example, four ADCs at 500 MHz each (or 8 ADCs at 250 MHz etc.). The input signal r'(t) may be multiplexed at 2 GHz between the ADCs, for example ADCs 210, ..., 214. The outputs of the ADCs 210, ..., 214 may also be demultiplexed at 2 GHz, into the data stream *y*[*n*]. In this manner, the ADCs 210, ..., 214 may operate a reduce sampling rate, with respect to the overall sampling rate.

The S/P converter 218 may comprise suitable logic, circuitry and/or code that may be enabled to convert a discrete signal stream into a plurality of discrete data streams. The FFT block 220 may comprise suitable logic, circuitry and/or code that may be enabled to efficiently generate a discrete Fourier transform (DFT) of the input data. The plurality of multipliers 222, ..., 228 may comprise suitable logic, circuitry and/or code that may be enabled to perform a (complex) multiplication of its input signals and generate an output signal that may be proportional to the product of the input signals. In some instances, the multipliers 222, ..., 228 may be implemented as amplifiers. The P/S converter 230 may comprise suitable logic, circuitry and/or code that may be enabled to convert multiple parallel input streams into a single output stream. The QAM demodulator 232 may comprise suitable logic, circuitry and/or code that may be enabled to demodulate a QAM modulated input signal. In some instances, modulation formats different from QAM may be used and the invention may not be limited to QAM.

The received radio frequency signal *r*(*t*) may be received at the antenna 202 and may be communicatively coupled to the demodulator 204. At the demodulator 204, the received signal *r*(*t*) may be converted to baseband and bandlimited in the LPF 206. At the output of the LPF 206, the band-limited received baseband signal r'(t) may be converted from analog to digital for further processing in the ping-pong ADC 234. The digital baseband signal *y*[*n*] at the output of the ping-pong ADC 234 may be converted from a serial to a parallel stream in the S/P converter 218. For example, as illustrated in FIG. 2C, *N* data streams may be created from *y*[*n*]. The N data streams generated in the S/P converter 218 may be communicatively coupled to the FFT block 220. Hence, the output signal of the FFT block 220 may be {*Y*[0],...,*Y*[*N*-1} = *FFT*(*y*[0],...,*y*[*N*-1]). The signals {*Y*[*n*]} may correspond to the frequency components in the sub-bands, or tones, of the received baseband signal.

The outputs of the FFT block 220 may be approximately given by the following relationship, *Y*[*i*] = *H*[*i*]*X*[*i*], where *H*[*i*] = *H̃*[*i*] + *A*[*i*] may be the overall channel transfer function which may, for example, comprise a baseband low-pass equivalent channel transfer function *H̃*[*i*] and a transfer function *A*[*i*] due to the distortion introduced by the ping-pong ADC 234. Hence, in accordance with various embodiments of the invention, the distortion introduced by the channel transfer function comprising the ping-pong ADC 234 distortion A[i], may be achieved, for example, by choosing the adjustment coefficients as *a*[*i*] =1 / *H*[*i*], for the tone for which *H*[*i*] may be estimated from a pilot tone.

By suitably choosing the adjustment coefficients {*a*[*n*]}, the signal {*Y*[*n*]} may at least partially correct the frequency distortion introduced. In some instances, it may be desirable to inject a controlled signal into the demodulator 204 to calibrate the receiver 200. This may be achieved, for example by switching the output of the calibration signal generator 238 via the switch 236 to the input of the demodulator 204. In these instances, the baseband low-pass equivalent channel transfer function may be approximately {*H̃*[*i*]} = 1 and hence the adjustment coefficients {*a*[*i*]} may be set to calibrate the distortion due to the ping-pong ADC 234 transfer function {*A*[*i*]}.

Since, in accordance with FIG. 2A and FIG. 2B, only some tones may be pilot tones and may be used for calibration, the coefficients *a*[*n*] may be determined from *a*[*n*] =1 / *H*[*n*] as described above for pilot tones. For channels (or tones) which may not be pilot-tones, and may hence not be directly estimated, the coefficients may be determined, for example, by linear interpolation from nearby estimated pilot tones. The determination of the coefficients may, however, not be limited to linear interpolation and may be achieved by arbitrary means. The adjusted outputs of the multipliers 222, ..., 228 may be communicatively coupled to the P/S converter 230, where the inputs may be converted into a single output stream for demodulation in the QAM demodulator 232.

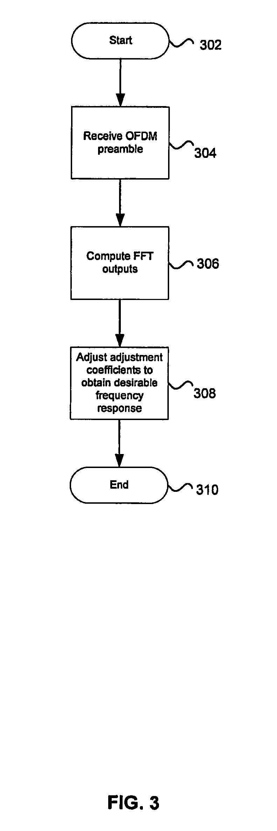

FIG. 3 is a flow chart illustrating an exemplary ADC calibration process for OFDM, in accordance with an embodiment of the invention. The calibration process may be initialized in step 302. In step 304, the OFDM receiver, for example the OFDM receiver 200, may receive a preamble signal, with pilot tones that may be spread across the OFDM bandwidth, as illustrated in FIG. 2A. As described in FIG. 2C, the received signal and/or the calibration signal that may generate the preamble signal, may be processed. In step 306, the FFT of the baseband signal may be generated, and the resulting signal {*Y*[*n*]} may be inspected for distortion. In some instances, the transmitted pilot tones may be of similar amplitude, as illustrated in FIG. 2A, and hence the outputs {*Y*[*n*]} of the FFT block, for example, FFT block 220, may be preferred of similar amplitude and appropriate phase to avoid distortion. Distortion may be reduced by adjusting the complex gains of the FFT block outputs, and/or by adjusting the adjustment coefficients {*a*[*n*]}. As described for FIG. 2C, in some instances, the input signal may be switched to a calibration signal generator, for example calibration signal generator 238 to effectively bypass the wireless channel, and calibrate the distortion due to the ping-pong ADC 234, for example.

In accordance with an embodiment of the invention, a method and system for ADC calibration in OFDM systems may comprise receiving a plurality of Orthogonal Frequency Division Multiplexing (OFDM) tones, as illustrated in FIG. 2B, at an OFDM receiver 200 comprising a ping-pong Analog-to-Digital Converter (ADC) 234 and a Fast-Fourier Transform (FFT) 220. A transfer function of the ping-pong ADC may be calibrated via one or more adjustment coefficients, for example {*a*[*n*]}, at one or more corresponding outputs of the FFT, based on processing of the plurality of the OFDM tones, as illustrated in FIG. 2C. The plurality of OFDM tones may be received in an OFDM preamble, as described in FIG. 3, or the received plurality of OFDM tones may be generated in a calibration signal generator 238, as described in FIG. 2C. As described for FIG. 2B, the output levels of the outputs of the FFT 220 may be equalized to achieve the calibration of the transfer function. The adjustment coefficients, for example {*a*[*n*]}, may be varied, and said calibrating may be performed dynamically.
The transfer function of the ping-pong ADC 234 may be frequency-selective, similar to FIG. 2B, and the ping-pong ADC 234 may comprise a plurality of ADCs, for example 210, 212, and 214 as illustrated in FIG. 2C. One or more adjustment coefficients may be generated by interpolating between adjustment coefficients corresponding to said plurality of OFDM tones. A frequency response of said OFDM receiver may be adjusted to achieve said calibrating.

Another embodiment of the invention may provide a machine-readable storage, having stored thereon, a computer program having at least one code section executable by a machine, thereby causing the machine to perform the steps as described above for a method and system for ADC calibration in OFDM systems.

Accordingly, the present invention may be realized in hardware, software, or a combination of hardware and software. The present invention may be realized in a centralized fashion in at least one computer system, or in a distributed fashion where different elements are spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

## Claims

1. A method for processing communication signals, the method comprising:
receiving a plurality of Orthogonal Frequency Division Multiplexing (OFDM) tones at an OFDM receiver comprising a ping-pong Analog-to-Digital Converter (ADC) and a Fast-Fourier Transform (FFT); and
calibrating a transfer function of said ping-pong ADC via one or more adjustment coefficients at one or more corresponding outputs of said FFT, based on processing of said plurality of said OFDM tones.

2. The method according to claim 1, comprising receiving said plurality of OFDM tones in an OFDM preamble.

3. The method according to claim 1, wherein said received plurality of OFDM tones is generated in a calibration signal generator.

4. The method according to claim 1, comprising equalizing output levels of said outputs of said FFT to achieve said calibration of said transfer function.

5. The method according to claim 1, comprising varying said one or more adjustment coefficients.

6. A system for processing communication signals, the system comprising:
one or more circuits in an Orthogonal Frequency Division Multiplexing (OFDM) receiver, said one or more circuits comprising a ping-pong Analog-to-Digital Converter (ADC) and a Fast-Fourier Transformer (FFT), wherein said one or more circuits are enabled to:
receive a plurality of Orthogonal Frequency Division Multiplexing (OFDM) tones by said OFDM receiver; and
calibrate a transfer function of said ping-pong ADC via one or more adjustment coefficients at one or more corresponding outputs of said FFT, based on a processing of said plurality of said OFDM tones.

7. The system according to claim 6, wherein said one or more circuits receive said plurality of OFDM tones in an OFDM preamble.

8. The system according to claim 6, wherein said received plurality of OFDM tones is generated in a calibration signal generator.

9. The system according to claim 6, wherein said one or more circuits equalize output levels of said outputs of said FFT to achieve said calibration of said transfer function.

10. The system according to claim 6, wherein said one or more circuits vary said one or more adjustment coefficients.
